# EUROPEAN PATENT APPLICATION

(11) **EP 3 336 964 A1**
(43) Date of publication of application: **20.06.2018**
(21) Application number: 16836564.1
(22) Date of filing: 08.08.2016
(51) Int. Cl.: H01Q 1/38

(54) **PRINTED CABLE AND MANUFACTURE METHOD THEREOF, CONNECTING CABLE, AND ELECTRICALLY TUNED ANTENNA SYSTEM**

(30) Priority: 14.08.2015 CN 201510502621
(71) Applicant: Comba Telecom Systems (Guangzhou) Ltd., Guangdong 510663 (CN)
(72) Inventor: PAN, Peifeng, Guangdong 510663 (CN); MA, Zefeng, Guangdong 510663 (CN); RONG, Zhenchun, Guangdong 510663 (CN); LIU, Peitao, Guangdong 510663 (CN); DUAN, Hongbin, Guangdong 510663 (CN); LIU, Shequan, Guangdong 510663 (CN)
(74) Representative: Patentanwälte Bals & Vogel
(86) International application number: PCT/CN2016/093997
(87) International publication number: WO 2017/028700

(57) **Abstract**

A printed cable for an antenna, comprising: a printed cable body (110); printed cable connecting terminals (120) provided on both ends of the printed cable body (110), the printed cable body (110) comprising: a substrate; a signal transmission layer (111) printed on the substrate; and an insulating material layer (112) printed on the substrate and located on both sides of the signal transmission layer (111). This optimizes the electromagnetic shielding effect, solves the technical problem of a built-in control drive unit of an electrically tuned antenna causing the third-order intermodulation performance of an antenna passive body to be degraded, and achieves the technical effect of the built-in control drive unit having a minimal influence on the third-order intermodulation performance of the antenna body. Further provided are a manufacture method of a printed cable, an antenna control and drive connection cable, and an electrically tuned antenna system.

## Description

This application claims the benefit of Chinese Patent Application No. 201510502621.4, filed with the Chinese Patent Office on August 14, 2015 and entitled "Printed cable and method for manufacturing the same, a connecting cable, and an electrically tuned antenna system", which is hereby incorporated by reference in its entirety.

### Field

The present invention relates to the field of antennas, and particularly to printed-circuit cable and method for manufacturing the same, a connecting cable, and an electrically adjusted antenna system.

### Background

An electrically adjusted antenna refers to a technology to control the angle of an antenna phase shifter using an electrical signal to thereby vary a coverage area in which a signal is received over the antenna. Electrically adjusted antenna controller device and driver device have been more and more widely applied in the field of antennas along with rapid development of an intelligent antenna. Particularly the controller device and the driver device are built in the electrically adjusted antenna, and electrically connected over a cable to thereby tune precisely the phase shifter, a reflecting plate, and other components in the electrically adjusted antenna so as to vary in effect a radiation range of the antenna.

In the industry, generally the controller device and the driver device in the electrically adjusted antenna are electrically connected over a common cable. Advantages of this arrangement are a low cost, and easiness to impellent, and disadvantages thereof are low performance of shielding, and a significant influence upon a specification of passive intermodulation of the antenna. This arrangement can be practiced for now in an antenna for which a low specification of passive intermodulation of the antenna is required; but this arrangement may be difficult to practice for an antenna for a high specification of passive intermodulation of the antenna is required, or has to be practiced at a high cost including a high economic cost, a large structural space of the antenna, etc. In the meanwhile, a multi-frequency intelligent antenna has been more and more widely applied, so that more phase shifter driver devices are required for more operating frequency bands, where they have to be connected with the controller device through more complex connection terminals over more connection cables, thus resulting in a more pronounced influence of the controller and driver devices, and the connection cables on the three-order intermodulation performance of the antennas, and also more instability factors.

Also such an arrangement has been adopted in the industry that the controller device, the driver device, and the connection cable are shielded directly using a tin foil, a copper bellows, or even a metal shielding structural cavity in addition to the common cable, but this arrangement suffers from high production and installation difficulties, and requires a large structural space internal to the antenna to be occupied, thus discouraging the antenna from being miniaturized.

Accordingly there is highly desirable to provide a novel connection cable for an antenna so as to address the disadvantages and drawbacks in the prior art above.

### Summary

An embodiment of the invention is to provide a printed cable for an antenna so as to advantageously address the problem in the prior art of the three-order intermodulation performance of the passive body of the electrically adjusted antenna being degraded due to the antenna controller and driver connection cable, to alleviate the design problems of the voluminous cable of the controller, the complex connector, and the instable three-order intermodulation performance, in the multi-frequency electrically adjusted antenna, and to accommodate the electrical connection of the controller and driver devices in the antenna at a low cost, so as to control the angle of the antenna phase shifter effectively in the controller and driver system of the electrically adjusted antenna.

In order to attain this object, there are the following technical solutions of the invention.

An embodiment of the invention provides a printed cable for an antenna, the printed cable including a printed cable body, and printed cable connection terminals arranged on two ends of the printed cable body, where the printed cable body includes a substrate, a signal transmission layer printed on the substrate, and two insulating material layers printed on the substrate, and located on two sides of the signal transmission layer.

Preferably the printed cable further includes shielding layers arranged on the outsides of the two insulating material layers, and insulating material layers on the outsides of the shielding layers.

Preferably the printed cable connection terminals are structured integral to the printed cable body.

Preferably the printed cable connection terminals are a rigid, or flexible, or rigid and flexible golden-finger-shaped or disk-shaped printed circuit board.

An embodiment of the invention further provides a method for manufacturing a printed cable, the method including the steps of:
forming a signal transmission layer on a substrate in a printed circuit board production lamination process;
forming two insulating material layers on two sides of the signal transmission layer in a printed circuit board productive lamination process; and
connecting printed cable connection terminals respectively on two ends of the signal transmission layer.

Preferably the method further includes:
forming two shielding layers on two sides of the two insulating material layers in a printed circuit board production lamination process; and
forming insulating material layers on the outsides of the two shielding layers in a printed circuit board production lamination process.

Preferably the printed cable connection terminals are connected respectively on the two ends of the formed signal transmission layer by connecting the printed cable body with the printed cable connection terminals in a printed circuit board production lamination process or welding process.

An embodiment of the invention further provides an antenna controller and driver connection cable including: at least one connection cable body, and connection terminals arranged respectively on two ends of the at least one connection cable body, where the connection cable body includes: a top insulating layer, a top electromagnetic film shielding layer, a top signal layer, a substrate insulating layer, a bottom signal layer, a bottom signal insulating layer, a bottom electromagnetic film shielding layer, and a bottom insulating layer, which are laminated and printed.

Preferably there are a number of connection cable bodies, each of which has one end on which there is one connection terminal, and the other end where there is a connection terminal connected with respective one of the connection cable bodies.

Preferably the connection terminals are covered with the top electromagnetic film shielding layer and the bottom electromagnetic film shielding layer of the connection cable body, and there are through-holes, communicating with the top signal layer, on the sections of the top electromagnetic film shielding layer and the bottom electromagnetic film shielding layer where the connection terminals are covered.

An embodiment of the invention further provides an electrically adjusted antenna system including a housing, a control module, a motor module, and the antenna controller and driver connection cable above, where the control module is arranged in the housing, and connected with the motor module over the antenna controller and driver connection cable.

The invention has the following advantages over the prior art:
with the designing and manufacturing process using a printed circuit board, the rigid printed circuit board and the flexible printed circuit board are designed and manufactured integral, so that the cable can be manufactured with highly uniform performance in a simplified process; and also the top of the rigid printed circuit board, and the underlying signal area are covered with the pure copper cladding, the top and the bottom respectively of the flexible printed circuit board are covered and laminated with the electromagnetic shielding film until the inside or upper and lower surfaces of the rigid printed circuit board are covered with the electromagnetic shielding film for the effect of covering and shielding the entire area of the cable from an electrical signal so as to address the problem in the prior art of the three-order intermodulation performance of the passive body of the electrically adjusted antenna being degraded due to the antenna controller and driver connection cable, and to accommodate the electrical connection of the controller and driver devices in the electrically adjusted antenna at a low cost, effectively in the controller and driver system of the electrically adjusted antenna.

### Brief Description of the Drawings

Fig.1 is a principle diagram of a printed cable for an antenna according to an embodiment of the invention.
Fig.2 is a principle diagram of an application in an antenna system according to an embodiment of the invention.
Fig.3 is a plan view of connection cables of controller and driver devices in an antenna according to an embodiment of the invention.
Fig.4 is a diagram of a shielding film laminated on the connection cables of the controller and driver devices in the antenna.
Fig.5 is a diagram of a shielding film embedded in the connection cables of the controller and driver devices in the antenna.

### Detailed Description of the Embodiments

The invention will be further described below with reference to the drawings and the embodiments thereof.

An embodiment of the invention provides a printed cable for an antenna. The printed cable includes a printed cable body, and printed cable connection terminals arranged on two ends of the printed cable body, where the printed cable body includes a substrate, a signal transmission layer printed on the substrate, and two insulating material layers printed on the substrate, and located on two sides of the signal transmission layer.

Particularly the printed cable further includes shielding layers arranged on the outsides of the two insulating material layers, and insulating material layers arranged on the outsides of the shielding layers, where the printed cable connection terminals are structured integral to the printed cable body. The printed cable connection terminals are a rigid, or flexible, or rigid and flexible golden-finger-shaped or disk-shaped printed circuit board.

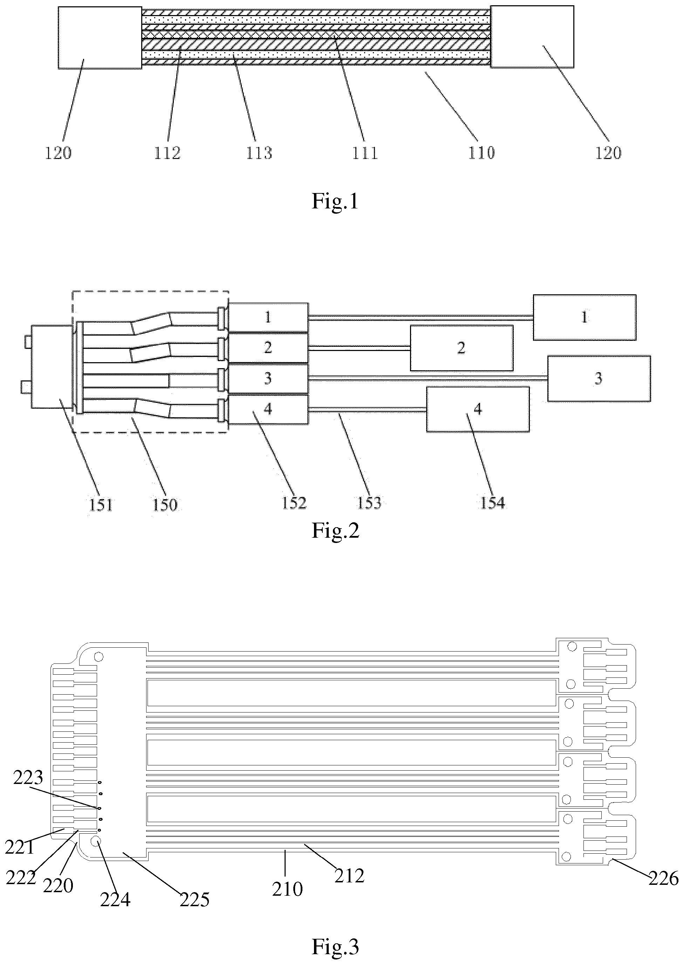

Referring to Fig.1, a printed cable for an antenna includes a printed cable body 110, and printed cable connection terminals 120 arranged on two ends of the printed cable body 110. The printed cable body 110 includes such layers of electrically conductive and insulating materials including one or more of an insulating material layer 112, a signal transmission layer 111, and a shielding layer 113 that are laminated in a printed circuit board production process to perform one or more of three functions of electrical conductivity, electrical signal shielding, and electrical insulation. The printed cable connection terminals 120 can be designed in a printed circuit board design process, where they are manufactured integral to or separate from the printed cable body, thus resulting in a rigid, or flexible, or rigid and flexible golden-finger-shaped or disk-shaped or otherwise-shaped printed circuit board electrically connected and physically connected with the printed cable body in a printed circuit board production lamination process or welding process; or electronic elements electrically connected and physically connected with the printed cable body in a printed circuit board production surface-adhering process or welding process using common electronic plugs. The printed cable body 110 and the printed cable connection terminals 120 are connected together in a printed circuit board manufacturing process or welding process to thereby transmit an electrical signal, and install and fix the cable for the purpose of the invention.

Fig.2 illustrates an application of the printed cable for an antenna in Fig.1 in an antenna system. As illustrated in Fig.2, a printed cable 150 has one terminal connected with an electrically adjusted antenna controller 151, and the other terminal connected with a respective electrically adjusted antenna driver unit 152. The electrically adjusted antenna controller 151 and the electrically adjusted antenna driver unit 152 are electrically connected over the printed cable 150. The electrically adjusted antenna driver unit 152 is connected in a transmission mode with an antenna phase shifter 154 through an antenna transmission screw 153. If the electrically adjusted antenna needs to have the angle of the phase shifter adjusted, then a drive signal issued by the electrically adjusted antenna controller 151 will be transmitted to the electrically adjusted antenna driver unit 152 over the printed cable 150, and an output moment of the electrically adjusted antenna driver unit 152 will be further transmitted to the antenna phase shifter 154 through the antenna transmission screw 153, and pull the antenna phase shifter 154 to move linearly so as to adjust the angle of the antenna phase shifter.

An embodiment of the invention further provides a method for manufacturing a cable, the method including the steps of:
forming a signal transmission layer on a substrate in a printed circuit board production lamination process;
forming two insulating material layers on two sides of the signal transmission layer in a printed circuit board productive lamination process; and
connecting printed cable connection terminals respectively on two ends of the signal transmission layer.

As can be apparent from the method above, a rigid printed circuit board and a flexible printed circuit board are designed and manufactured integral, so that the cable can be manufactured with highly uniform performance in a simplified process; and also the top of the rigid printed circuit board, and an underlying signal area are covered with a pure copper cladding, the top and the bottom respectively of the flexible printed circuit board are covered and laminated with an electromagnetic shielding film until the inside or upper and lower surfaces of the rigid printed circuit board are covered with the electromagnetic shielding film for the effect of covering and shielding the entire area of the cable from an electrical signal so as to address the problem in the prior art of the three-order intermodulation performance of the passive body of the electrically adjusted antenna being degraded due to the antenna controller and driver connection cable, and to accommodate the electrical connection of the controller and driver devices in the electrically adjusted antenna at a low cost, effectively in the controller and driver system of the electrically adjusted antenna.

Preferably the method above further includes:
forming two shielding layers on two sides of the two insulating material layers in a printed circuit board production lamination process; and
forming insulating material layers on the outsides of the two shielding layers in a printed circuit board production lamination process;
where the connecting printed cable connection terminals respectively on two ends of the signal transmission layer includes connecting the printed cable body with the printed cable connection terminals in a printed circuit board production lamination process or welding process.

An embodiment of the invention further provides an antenna controller and driver connection cable including at least one connection cable body, and connection terminals arranged respectively on two ends of the at least one connection cable body, where the connection cable body includes: a top insulating layer, a top electromagnetic film shielding layer, a top signal layer, a substrate insulating layer, a bottom signal layer, a bottom signal insulating layer, a bottom electromagnetic film shielding layer, and a bottom insulating layer, which are laminated and printed.

Where there are a number of connection cable bodies, each of which has one end on which there is one connection terminal, and the other end where there is a connection terminal connected with respective one of the connection cable bodies.

Particularly the connection terminals are covered with the top electromagnetic film shielding layer and the bottom electromagnetic film shielding layer of the connection cable body, and there are through-holes, communicating with the top signal layer, on the sections of the top electromagnetic film shielding layer and the bottom electromagnetic film shielding layer where the connection terminals are covered.

Fig.3 illustrates connection cables of controller and driver devices in an antenna according to the embodiment of the invention in Fig.1. As illustrated in Fig.3, the antenna controller and driver connection cable includes a connection terminal 220 arranged on one end of an antenna controller and driver connection cable body 210 to be connected with an electrically adjusted antenna controller 151; and four small connection terminals 226 arranged on the other end thereof to be electrically connected with four electrically adjusted antenna driver units 152. Electrical connection over the connection cable is primarily established using printed cable body signal connection lines 212 made of a flexible printed circuit board material capable of being bent at 180 degrees without degrading the electrical performance thereof. The connection terminal 220 made of a rigid printed circuit board material includes golden-finger pads 221, and wires 222 connecting the through-holes 223 with the golden-finger pads; the through-holes 223 are electrically connected with the printed cable body signal connection lines 212 through an inner signal layer; and the rigid printed circuit board is covered by a shielding copper cover layer 225, and the connection line is installed and fixed with an external structure through installation holes 224.

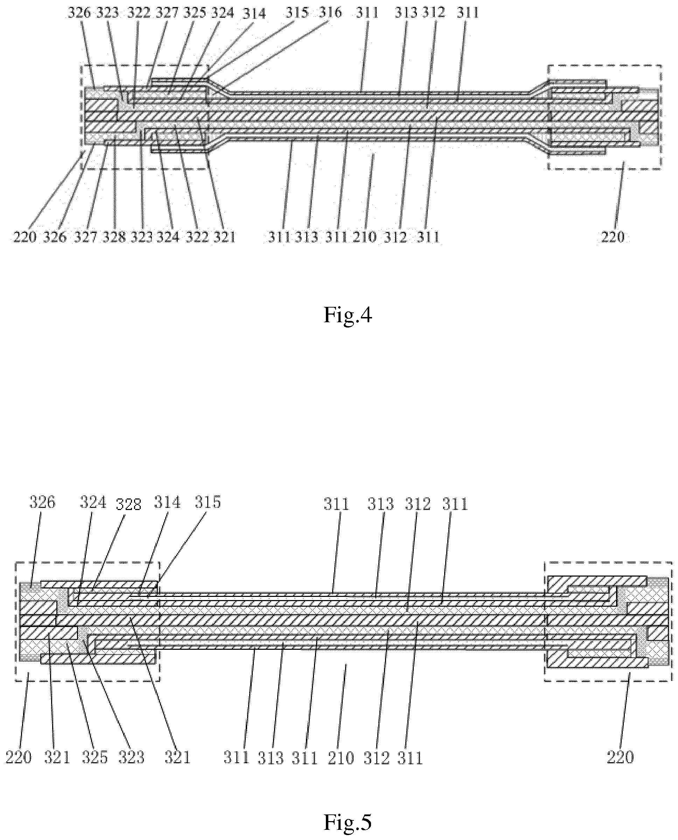

Fig.4 illustrates a laminated diagram of a shielding film laminated on the connection cables of the controller and driver devices in the antenna according to the embodiment of the invention in Fig.3. As illustrated in Fig.4, the cable body 210 of the antenna controller and driver connection cable includes a top insulating layer 311, a top electromagnetic film shielding layer 313, a top signal insulating layer 311, a top signal layer 312, an underlying insulating layer 311, a bottom signal layer 312, a bottom signal insulating layer 311, a bottom electromagnetic film shielding layer 313, and a bottom insulating layer 311, laminated from the top to the bottom in a printed circuit board manufacturing process to perform functions of conducting a signal, shielding a signal, and insulating a signal. The connection terminal 220 of the antenna controller and driver connection cable includes a top insulating layer 327, a top golden-finger pad 326, a top signal layer 325, a through-hole 323, an inner top insulating layer 324, an inner top signal layer 322, an inner insulating layer 321, an inner bottom signal layer 322, a through-hole 323, an inner bottom insulating layer 324, a bottom signal layer 328, a bottom golden-finger pad 326, and a bottom insulating layer 327, laminated from the top to the bottom in a printed circuit board manufacturing process to perform functions of conducting a signal, shielding a signal, and insulating a signal. Particularly the top insulating layer 311, the top electromagnetic film shielding layer 313, the bottom electromagnetic film shielding layer 313, and the bottom insulating layer 311 of the cable body 210 are laminated together with the top and bottom copper cover layers of the rigid connection terminal in a rigid and flexible hybrid circuit board production hybrid lamination process, and an electromagnetic film shielding layer 314, an insulating layer 315, and a dotted glue layer 316 are formed in the rigid area to fill a step between different heights at the site where the rigid area and the flexible area adjoin during rigid and flexible hybrid lamination, for the purpose of smooth transition so as to prevent the shielding films from being leaked or damaged due to the step. Since the electromagnetic shielding film 314 and the copper cover layer overlap and cover, the cable body, and both of the ends of the cable connection terminal are completely covered and shield for the purpose of the invention.

Fig.5 illustrates a laminated diagram of a shielding film embedded in the connection cables of the controller and driver devices in the antenna according to the embodiment of the invention in Fig.3. A manufacturing process thereof is similar to the solution in Fig.4 except that the electromagnetic films are embedded between the inner signal insulating layer 324 and the top signal layer 325 in the rigid area in an embedded lamination process, and also the electromagnetic films and the copper cover layer overlap and shield to the effect for the purpose of the invention.

An embodiment of the invention further provides an electrically adjusted antenna system including: a housing, a control module, a motor module, and the antenna controller and driver connection cable according to any one of the embodiments above, where the control module is arranged in the housing, and connected with the motor module over the antenna controller and driver connection cable.

Particularly the antenna system includes the antenna controller and driver connection cable, the control module, the motor module, a phase shifter, an antenna radiating body, and the housing, where the control module is installed in the housing of the antenna. The control module is embedded in a top cover and the housing of the antenna, and the control module can be pulled out of or inserted into an installation hole in the top cover. The antenna controller and driver connection cable is electrically connected with the control module, and the antenna controller and driver connection cable is electrically connected with the motor module. The motor module is mechanically connected with the phase shifter, or the antenna controller and driver connection cable is inserted into the control module and/or the motor module.

The foregoing embodiments are preferred embodiments of the invention, but the invention will not be limited thereto, but any other variations, modifications, equivalents, combinations, simplifications, etc., made without departing from the spirit and the principle of the invention shall be equivalently encompassed in the claimed scope of the invention.

## Claims

1. A printed cable for an antenna, comprising a printed cable body, and printed cable connection terminals arranged on two ends of the printed cable body, wherein the printed cable body comprises a substrate, a signal transmission layer printed on the substrate, and two insulating material layers printed on the substrate, and located on two sides of the signal transmission layer.

2. The printed cable according to claim 1, wherein the printed cable further comprises shielding layers arranged on the outsides of the two insulating material layers, and insulating material layers on the outsides of the shielding layers.

3. The printed cable according to claim 1, wherein the printed cable connection terminals are structured integral to the printed cable body.

4. The printed cable according to claim 3, wherein the printed cable connection terminals are a rigid, or flexible, or rigid and flexible golden-finger-shaped or disk-shaped printed circuit board.

5. A method for manufacturing a printed cable, the method comprising:
forming a signal transmission layer on a substrate in a printed circuit board production lamination process;
forming two insulating material layers on two sides of the signal transmission layer in a printed circuit board productive lamination process; and
connecting printed cable connection terminals respectively on two ends of the signal transmission layer.

6. The method for manufacturing a printed cable according to claim 5, wherein the method further comprises:
forming two shielding layers on two sides of the two insulating material layers in a printed circuit board production lamination process; and
forming insulating material layers on the outsides of the two shielding layers in a printed circuit board production lamination process.

7. The method for manufacturing a printed cable according to claim 5, wherein connecting printed cable connection terminals respectively on two ends of the signal transmission layer comprising: connecting the printed cable body with the printed cable connection terminals in a printed circuit board production lamination process or welding process.

8. An antenna controller and driver connection cable, comprising: at least one connection cable body, and connection terminals arranged respectively on two ends of the at least one connection cable body, wherein the connection cable body comprises: a top insulating layer, a top electromagnetic film shielding layer, a top signal layer, a substrate insulating layer, a bottom signal layer, a bottom signal insulating layer, a bottom electromagnetic film shielding layer, and a bottom insulating layer, which are laminated and printed.

9. The antenna controller and driver connection cable according to claim 8, wherein there are a number of connection cable bodies, each of which has one end on which there is one connection terminal, and the other end where there is a connection terminal connected with respective one of the connection cable bodies.

10. The antenna controller and driver connection cable according to claim 9, wherein the connection terminals are covered with the top electromagnetic film shielding layer and the bottom electromagnetic film shielding layer of the connection cable body, and there are through-holes, communicating with the top signal layer, on the sections of the top electromagnetic film shielding layer and the bottom electromagnetic film shielding layer where the connection terminals are covered.

11. An electrically adjusted antenna system, comprising: a housing, a control module, a motor module, and the antenna controller and driver connection cable according to any one of claims 8 to 10, wherein the control module is arranged in the housing, and connected with the motor module over the antenna controller and driver connection cable.
